# EUROPEAN PATENT APPLICATION

(11) **EP 2 800 130 A1**
(43) Date of publication of application: **05.11.2014**
(21) Application number: 13165820.5
(22) Date of filing: 29.04.2013
(51) Int. Cl.: H01L 21/60, H01L 23/13, H01L 23/495, H01L 23/051

(54) **Chip-to-substrate transient liquid phase bonding using a spacer**

(71) Applicant: ABB Technology AG, 8050 Zürich (CH)
(72) Inventor: Brem, Franziska, 8700 Küsnacht (CH); Liu, Chunlei, 5406 Rütihof (CH); Duran, Hamit, 5300 Turgi (CH)
(74) Representative: ABB Patent Attorneys

(57) **Abstract**

A method for bonding an electronics chip (10) to a substrate (12), the method comprising the steps of: coating a bonding area (14) of the chip (10) with a first metal layer (18); providing a bonding area (24) of the substrate (12) and/or the bonding area (14) of the chip (10) with a low melting point metal layer (30), wherein the bonding area (24) of the substrate (12) comprises a second metal layer (28); attaching a spacer (20) to the chip (10) and/or the substrate (12); positioning and fixing the chip (10) on the substrate (12); and transient liquid phase bonding the chip (10) to the substrate (12) by melting the low melting point layer (30), wherein the spacer (20) provides a specific distance between the first metal layer (18) and the second metal layer (28).

## Description

### Field of the invention

The invention relates to the field of manufacturing of electronic devices and packaging of electronic components. In particular, the invention relates to a method of contacting an electronics chip and connecting it electrically to a substrate and to an electronics chip package.

### Background of the invention

Classic packaging technologies such as aluminium (AI) wire bonding are considered as the limiting factor for better performance of power electronics modules and packages. Further, new applications require different dimensions and more compact design of power electronic modules.

Planar emitter contacts are a step towards these new design requirements. The main general trend of actual IGBT module manufacturers is eliminating the wire bonds implementing new interconnection solutions replacing the aluminum wires.

Transient liquid phase (TLP) bonding, more generally also called diffusion bonding or diffusion soldering has been investigated for electronics manufacturing since almost 20 years. This joining method is well suited to produce high-strength intermetallic joints at moderate process temperature with the merit that the operation temperature of the assembly can exceed the joining process temperature, as the resulting intermetallic joint has a higher melting temperature than the temperature that is used during the joining process. The physical principal of isothermal diffusion soldering is based on the solubility of a metal with higher melting point in the liquid of a low melting metal.

As the process is based on diffusion and the formation of intermetallic phases, the resulting joints are limited in thickness. The kinetic growth of the intermetallic phases directly determines the bond line thickness, and a joint only becomes reliable at higher temperature if the low melting metal is completely transferred into intermetallic compounds.

### Description of the invention

A manufacturing problem of the transient liquid phase process for emitter bonding may be that a very homogeneous bond line thickness needs to be achieved in order to transfer all low melting metal into intermetallic compounds without pressing the molten metal out of the joint during the bonding process. The surface roughness requirements may be important as well, as surface topology can lead to local capillary forces, and a non-uniform distribution of the liquid low melting metal may cause voids in the joint. These voids may reduce the contact area and may enhance the thermal and electric resistance in the joint.

It is an object to facilitate transient liquid phase bonding during the manufacturing of electronic packages.

This object is achieved by the subject-matter of the independent claims. Further exemplary embodiments are evident from the dependent claims and the following description.

An aspect of the invention relates to a method for bonding an electronics chip to a substrate, the method comprising the steps of: coating a bonding area or active area of the chip with a first metal layer; providing a bonding area of the substrate and/or chip with a low melting point metal layer, wherein the bonding area of the substrate comprises a second metal layer; attaching a spacer to the chip and/or the substrate; positioning and fixing the chip on the substrate; and bonding the chip with a transient liquid phase process to the substrate by melting the low melting point metal layer, wherein the spacer provides a specific distance between the first metal layer and the second metal layer.

Transient liquid phase bonding may provide a stable and cheap interconnection or joint between the chip and the substrate. With this bonding method, the reproducibility and quality of a joint may be enhanced.

With the spacer a homogeneous bond line thickness may be provided and process stability may be enhanced.

The spacer additionally may act as an electrical insulator. For example, the material of the spacer may be insulating and/or may provide a chip edge insulation.

The first metal layer may be seen as a first TLP joining partner and the second metal layer may be seen as a (second) TLP joining partner. For example, the metal material of both layers may be copper (Cu). The low melting point material of the intermediate low melting point metal layer may be tin (Sn).

During the bonding, the low melting point layer melts and a diffusion processes starts. At the end of this step a part of the two metal layers and the complete low melting point layer have been transformed into intermetallic compounds, which have a higher melting point than the low melting point material. The chip and the substrate are bonded by an intermetallic joint.

The low melting point layer may be either deposited on the chip or on the substrate. It is also possible that two low melting point layers are deposited on both the chip and the substrate. Possible deposition methods are foil plating, coating, position of metal foil between the chip and the substrate, etc.

During the bonding, the low melting point layer may be molten in a solder furnace or by induction heating.

According to an embodiment of the invention, the chip is positioned (upside down) above the substrate during the bonding. The bonding process may be made from top to bottom, facilitating homogeneous pressure distribution and alignment of the chip on the substrate.

According to an embodiment of the invention, the method further comprises the step of: coating the bonding area of the chip with a barrier layer that prevents the diffusion of low melting point material into the chip. The barrier layer may be below the first metal layer and/or may be made of a metal material different from the material of the first metal layer, for example from Ti, Ni or Cr.

According to an embodiment of the invention, the spacer is a frame surrounding the bonding area of the chip and/or the substrate at least partially. For example, the frame may have a rectangular shape or may be a section of a rectangular shape.

According to an embodiment of the invention, the frame has a uniform thickness, i.e. the frame may be adapted to contact the chip and the substrate over its whole extension.

Alternatively, sections of the frame may have less thickness than other sections. For example, the frame may have shoulders, which also may help to guide the chip onto the substrate.

According to an embodiment of the invention, the spacer comprises at least two posts of uniform thickness, which may be located at a border of the bonding area. For example, four posts may be positioned at the corners of the bonding area.

According to an embodiment of the invention, the posts are interconnected with a bar less thick than the posts. For example, four posts may be interconnected with small bars at the bottom, which may facilitate the handling of the frame. Also a frame of non-uniform thickness may allow for gel filling, which may enhance insulation properties.

According to an embodiment of the invention, the spacer is made of plastic. The material of the spacer may be a polymer like polyimide. The spacer also may be made with a photoresist that for example is used in die or PCB manufacturing.

For example, the thickness of an insulating spacer may be about 0.5 mm. The thickness of the frame or of the posts may be 0.5 mm in this case.

According to an embodiment of the invention, the method further comprises the step of: patterning the spacer on the chip and/or the substrate. In this case, the spacer may be formed from a photoresist layer.

According to an embodiment of the invention, the spacer is made of metal. Also in this case, the spacer may provide an isolation, when an isolating layer is positioned between the chip and the spacer.

According to an embodiment of the invention, the method further comprises the step of: manufacturing the spacer separately from the chip and the substrate. It may be easier to pre-manufacture the frame (e.g. in an array) and to position it on the chip or on the substrate prior to the diffusion soldering process.

According to an embodiment of the invention, the method further comprises the step of: providing a termination layer between the chip and/or the substrate and the spacer. For example, the termination layer may be coated on the chip prior to the coating of the spacer material. The termination layer may be a non-conducting layer that is provided at the border of the bonding area, which may be the active area of the chip or the substrate. The termination layer may be used for insulation and/or for forming the electrical field near the active area of the chip.

According to an embodiment of the invention, the substrate is a lead frame or a metalized ceramics substrate.

A lead frame may be a metal (e.g. copper) bar that is also used for mechanically supporting the chip. More than one chip may be bonded to one lead frame. The metal material of the lead frame may provide the second metal layer that is used for the transient liquid phase bonding.

A metalized ceramics substrate may be a ceramics plate that has a metal (e.g. copper) layer on its side. The material of the metal layer may provide the second metal layer that is used for the transient liquid phase bonding.

According to an embodiment of the invention, the first metal layer and the second metal layer are copper layers, and/or the low melting point metal layer is a tin layer. With a TLP system comprising copper and tin, the thickness of the tin layer may be about 25 µm.

Also other transient liquid phase systems are possible such as AgSnAg, AgInAg, etc.

According to an embodiment of the invention, the bonding area of the substrate is elevated with respect to a contact area of the frame. For example, the method may comprise the step of etching the substrate outside of its bonding area to generate an elevated bonding area.

The method as described above and in the following is especially suited in a flip chip process, since the spacer may provide for a well defined distance between the chip and the substrate, which distance provides the required insulation.

A further aspect of the invention relates to an electronics chip package. It has to be understood that features of the method as described in the above and in the following may be features of the package as described in the above and in the following, and vice versa.

According to an embodiment of the invention, the package comprises an electronics chip with a bonding area having a first metal layer; a substrate with a bonding area having a second metal layer; a spacer between the electronics chip and the substrate; wherein the chip and the substrate are bonded with an intermediate metal layer between the first metal layer and the second metal layer; wherein the spacer is adapted to provide a specific distance between the first metal layer and the second metal layer in the case, the intermediate layer is molten. For example, the chip may be an IGBT and may be bonded via its emitter contact to a lead frame as substrate. The intermediate metal layer may be a layer of a metal compound that has been formed during transient liquid phase bonding of the chip to the substrate.

The electronics chip package may have been produced by the method as described in the above and in the following. It has to be mentioned that the production of the chip may be adapted to other joining methods like soft soldering of the emitter contact. In this case, the final melting point of the intermediate layer would be lower. An advantage of the transient liquid phase bonding may be the enhanced melting temperature of the formed intermetallic compounds.

These and other aspects of the invention will be apparent from and be elucidated with reference to the embodiments described hereinafter.

### Brief description of the drawings

The subject-matter of the invention will be explained in more detail in the following text with reference to exemplary embodiments which are illustrated in the attached drawings.
Fig. 1 schematically shows a cross-section through a chip and a substrate according to an embodiment of the invention.
Fig. 2 shows a flow diagram for bonding a chip to a substrate according to an embodiment of the invention.
Fig. 3 schematically shows a top view and a side view of a part of a lead frame for a chip package substrate according to an embodiment of the invention.
Fig. 4A schematically shows a top view of a spacer according to an embodiment of the invention.
Fig. 4B schematically shows a top view of a spacer according to another embodiment of the invention.
Fig. 4C schematically shows a top view of a spacer according to another embodiment of the invention.
Fig. 4D schematically shows a top view of a spacer according to another embodiment of the invention.
Fig. 5 schematically shows a cross-section through a chip package according to an embodiment of the invention.

In principle, identical parts are provided with the same reference symbols in the figures.

### Detailed description of exemplary embodiments

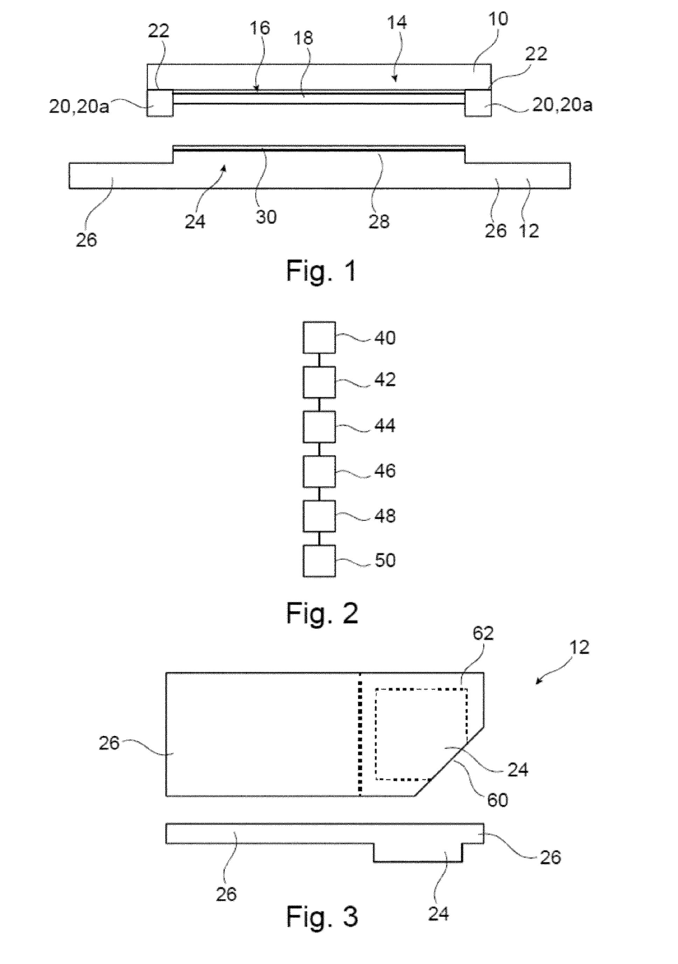

Fig. 1 shows an electronics semiconductor chip 10 and a substrate 12 before the bonding.

The chip 10 comprises a bonding area 14, which may be a part of the active area of the chip 10. For example, the chip 10 may be an IGBT and the active area may comprise the emitter of the IGBT and a gate pad.

Directly on the bonding area 14, the chip is coated with a metallization (for example Al or AlSi) and a diffusion barrier layer 16. Above the diffusion barrier layer 16, the chip is coated with a metal layer 18, which for example is a metal plating of copper.

A spacer 20 in the form of a frame 20a surrounds the diffusion barrier layer 16 and the metal layer 18. Between the spacer 20 and the chip there may be an edge termination and insulation layer 22.

As shown in Fig. 1, the substrate 12 may be a lead frame, which has been etched such that a bonding area 24 is elevated with respect to the etched parts 26 of the lead frame 12. The parts 26 may be seen as a half-etched structure of the lead frame 12. The bonding area 24 acts as an emitter contact or more general as electrical connection to the active area of chip 10.

The upper part of the lead frame 12 in the bonding area 24 may be seen as a second metal layer 28 that is the bonding partner of the metal layer 18 of the chip 10. In the case the substrate 12 is a metalized ceramic plate, the metal layer 28 may be a part of the metallization on the ceramic plate.

Above the metal layer 28, the bonding area 24 of the substrate 12 is coated with a low melting point metal layer 30, for example a tin layer 30.

Fig. 2 shows a flow diagram for a method for bonding the chip 10 to the substrate 12. In step 40, the bonding area 14 of the chip 10 is coated.

First, a thin adhesion/diffusion barrier layer 16 is coated on the bonding area 24 of the chip 10. The diffusion barrier layer 16 may be made of Ti, Ni or Cr. The layer 16 should prevent atoms diffusion into the semiconductor structure of the chip 10 below the metallization, and at the same time it should provide good adhesion towards the material of the first metal layer 18, which may be Cu.

Then, the metal layer 18 is deposited/coated on top of the adhesion/diffusion barrier 16. The metal layer 18 should provide a critical thickness depending on the material system for the TLP process. These coating steps may be done on wafer level with a mask process or else depending on the TLP material system and the deposition process.

During step 40, a gate pad as well as the edge termination layer 22 are spared out and not coated.

In step 42, the substrate 12 is prepared for the bonding process.

For example, the substrate 12 may be a lead frame 12, which is designed depending on chip dimensions and current/voltage requirements. The selected material may be copper (Cu), but may also be another metallic material. Copper has the advantage of having good electrical properties, and copper may be etched and plated easily.

Fig. 2 shows a part of a lead frame 12 from the top and from the side. In Fig. 2, a gate pad opening 60 and the half-etched structure 26 close to the bonding area 24 are depicted.

The bonding area 24 has the same size as the bonding area 14 of the chip 10 except an opening 60 for accessing the gate pad of the chip 10, for example for attaching a bond wire to the gate pad. The bonding area 24 has the full thickness of the lead frame 12, while the rest of the lead frame is half-etched.

The bonding area 42 is plated or coated with the low melting point metal layer 30 (for example Sn), for example by selective plating.

If another TLP material system as CuSnCu is chosen, both joining partners may be plated on the active area contact. I.e. the bonding area 24 has to be plated or coated with the second metal layer 28, before the coating or plating of the low melting point metal layer 30. The low melting point metal layer 30 also may be provided as a foil.

Alternatively or additionally it is possible that the bonding area 14 of the chip 10 is plated or coated with the low melting point metal layer 30.

In step 44, the spacer 20 is attached to the chip 10 or to the substrate 12. In Fig. 3, a possible contact area 62 of the spacer 20 with the substrate 12 is indicated.

The spacer 20 may be manufactured separately from the chip 10 or the substrate 12, or may be produced directly on the chip 10 or on the substrate 12. For example, the spacer 20 may be manufactured from a polymeric material like polyimide or may be patterned on the contact area 60 on the substrate or the corresponding contact area on the chip 10.

A spacer material which may be patterned is provided by e.g. lamination or spin coating. The spacer material may be a dry photoresist or (mostly epoxy-based, some polyimide-based) and may be patterned by UV radiation.

In the case that the spacer 20 is patterned on the chip 10, this step may also be done on wafer level, and the wafer may be diced with this frame material on top.

The gate pad of the chip 10 as well as the bonding areas 14, 24 are finally not covered by the spacer 20.

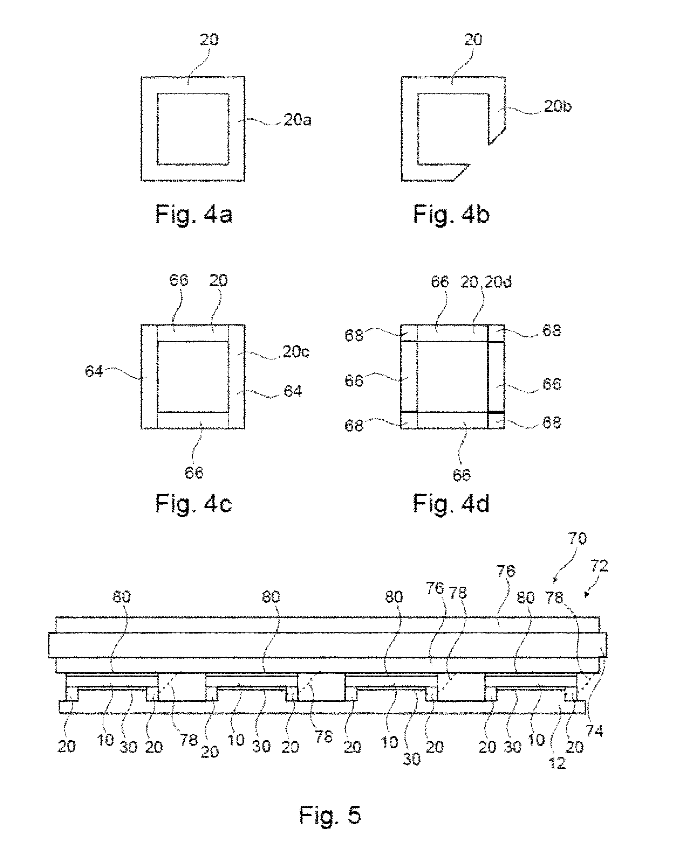

Figs. 4A to 4D show possible forms of the spacer. For example, the spacer 20 may be a (rectangular) frame 20a that completely surrounds a rectangular bonding area 14, 24.

It is also possible that the spacer 20 is only a part of the frame, leaving out the area of the gate pad of the chip 10, so that the gate pad may be accessed after the bonding of the chip to the substrate 12.

Both frames 20a, 20b may have uniform thickness.

It is also possible that spacers 20c, 20d with elements of different thickness are used. For example, the spacer 20c may have two shoulders 64 that are connected by bars 66 that are less thick than the shoulders 64. The shoulders 64 may be seen as elongated posts besides of the bonding areas 14, 24.

A further example would be a spacer 20d comprising four posts or pins 68 having the same thickness. The posts 68 may be interconnected by bars 66 that are less thick than the post 68.

The height or thickness of the spacer 20 (in particular of the shoulders 64 and the posts 68) is specified by its function as a spacer/distance holder in the TLP joining step. The bars 66 or joining members may facilitate the handling of the spacer 20.

In step 46, the chip 10 is positioned and fixed on the substrate 12.

For example, the chip 10 may be placed with its bonding area 14 on the bonding area 24 of the substrate 12. This step can be done by standard pick and place equipment. In any case, the chips 10 may have to be sorted in the waffles with the bonding area 14 down. Alternatively, the equipment may have to flip the chips directly from the sawing tape.

The fixation of the substrate 12 on a holder may be done with adjustment holes, and these may also act as alignment marks for a pick and place machine. The spacer 20 may have bevelled edges that facilitate the placement on the elevated bonding area 24.

Furthermore, the chip 10 may be fixed on the substrate 12 by a homogenous pressure on the opposite side of the chip 10 with respect to the bonding area 14, for example on the collector side of the chip 10.

In step 48, the chip 10 is bonded on the substrate 12. The chip 10 is bonded or joined to the substrate 12 by melting the low melting point layer 30. During this step, when the low melting point metal is molten, the spacer 20 provides a specific distance between the first metal layer 18 and the second metal layer 28, and the spacer 20 acts as a space holder providing homogeneous bond line thickness for the chip 10.

Step 48 may take place in a solder furnace equipment or by induction heating. In the end, an intermediate layer 30 of a metal compound has formed between the chip and the substrate 12.

Fig. 5 shows a chip package 70 with chips 10 bonded to a substrate 12. Fig. 5 shows that a plurality of chips 10 may be positioned and fixed on one substrate 12. The step 46 and 48 may also be executed with the chips 10 already bonded to another substrate 72. The substrate 72 may be another lead frame or a ceramics plate 74 with metallization layers 76.

It is also possible that the further substrate 70 is bonded to chip 10 also by a TLP process, resulting in a second intermediate layer 80 of a metal compound.

With planar emitter contacts also a two side cooling of the package 70 is possible.

Instead of a lead frame 12, a PCB or flex foil may be used as substrate 12. In this case, the gate connection of the chip 10 to the substrate 12 may be insulated and may be bonded by a TLP process, for example simultaneously with the TLP process in step 48. However, these emitter contacts may be limited to lower currents.

In step 50, further method steps may take place:

The chips 10 may be bonded to the further substrate 72, for example by soldering. In particular, the collector side of the chip 10 may be bonded to a direct bond copper substrate 70 or lead frame substrate.

The gate pads of the chips 10 may be wire-bonded after the steps mentioned above, as the lead frame 12 may provide room for the bonding tool. For example the gate pads may be accessed through the opening 60 in the lead frame 12, and wire bonds 78 may be attached to the gate pad and the further substrate 70.

The package 70 may be filled with silicone gel, for example through the openings 60.

A further bonding to a base plate is also possible.

It has to be noted that the method and the design may allow for batch processes in production.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

**List of references**

| | |
|---|---|
| 10 | chip |
| 12 | substrate |
| 14 | bonding area |
| 16 | diffusion barrier layer |
| 18 | first metal layer |
| 20,20a,20b 20c,20d | spacer |
| 22 | termination layer |
| 24 | bonding area |
| 26 | etched parts |
| 28 | second metal layer |
| 30 | low melting point metal layer |
| 40,42,44 46, 48 50 | steps |
| 60 | opening |
| 62 | contact area |
| 64 | shoulder |
| 66 | bar |
| 68 | posts |
| 70 | chip package |
| 72 | substrate |
| 74 | ceramics plate |
| 76 | metallization layer |
| 78 | wire bond |
| 80 | intermediate layer |

## Claims

1. A method for bonding an electronics chip (10) to a substrate (12), the method comprising the steps of:
coating a bonding area (14) of the chip (10) with a first metal layer (18);
providing a bonding area (24) of the substrate (12) and/or the bonding area (14) of the chip (10) with a low melting point metal layer (30), wherein the bonding area (24) of the substrate (12) comprises a second metal layer (28);
attaching a spacer (20) to the chip (10) and/or the substrate (12);
positioning and fixing the chip (10) on the substrate (12);
bonding the chip (10) by a transient liquid phase process to the substrate (12) by melting the low melting point metal layer (30), wherein the spacer (20) provides a specific distance between the first metal layer (18) and the second metal layer (28).

2. The method of claim 1, further comprising the step of:
coating the bonding area (14) of the chip (10) with a barrier layer (16) that prevents the diffusion of material from the first metal layer and/or the low melting point metal layer into the chip (10).

3. The method of claim 1 or 2,
wherein the spacer (20) is a frame (20a, 20b) surrounding the bonding area (14) of the chip (10) and/or the substrate (12) at least partially.

4. The method of claim 3,
wherein the frame (20a, 20b) has a uniform thickness.

5. The method of one of the preceding claims,
wherein the spacer (20) comprises at least two posts (64, 68) of uniform thickness, which are located at a border of the bonding area (14, 24).

6. The method of claim 5,
wherein the posts (64, 68) are interconnected with a bar (66) less thick than the posts (68).

7. The method of one of the preceding claims,
wherein the spacer (20) is made of plastic.

8. The method of one of the preceding claims,
wherein the spacer (20) is made of metal.

9. The method of one of the preceding claims, further comprising the step of:
patterning the spacer (20) on the chip and/or the substrate.

10. The method of one of the claims 1 to 8, further comprising the step of:
manufacturing the spacer (20) separately from the chip (10) and the substrate (12).

11. The method of one of the preceding claims, further comprising the step of:
providing a termination layer (22) between the chip (10) and/or the substrate (12) and the spacer.

12. The method of one of the preceding claims,
wherein the substrate (12) is a lead frame or a metalized ceramics substrate.

13. The method of one of the preceding claims,
wherein the first metal layer (18) and the second metal layer (28) are copper layers; wherein the low melting point metal layer (30) is a tin layer.

14. The method of one of the preceding claims,
wherein the bonding area (24) of the substrate (12) is elevated with respect to a contact area of the spacer (20).

15. An electronics chip package (70), comprising:
an electronics chip (10) with a bonding area (14) having a first metal layer (18);
a substrate (12) with a bonding area (24) having a second metal layer (28);
a spacer (20) between the electronics chip (10) and the substrate (12);
wherein the chip (10) and the substrate (12) are bonded with an intermediate metal layer (30) between the first metal layer (18) and the second metal layer (28);
wherein the spacer (20) is adapted to provide a specific distance between the first metal layer (18) and the second metal layer (28) in the case, the intermediate metal layer (30) is molten.
